# EUROPEAN PATENT APPLICATION

(11) **EP 1 705 694 A1**
(43) Date of publication of application: **27.09.2006**
(21) Application number: 04807561.8
(22) Date of filing: 22.12.2004
(51) Int. Cl.: H01L 21/027, G03F 7/20

(54) **EXPOSURE METHOD AND APPARATUS, AND DEVICE PRODUCING METHOD**

(30) Priority: 06.01.2004 JP 2004001150
(71) Applicant: NIKON CORPORATION, Tokyo 100-8331 (JP)
(72) Inventor: MIZUTANI, Takeyuki, c/o NIKON CORPORATION, Tokyo 100-8331 (JP)
(74) Representative: HOFFMANN EITLE
(86) International application number: PCT/JP2004/019204
(87) International publication number: WO 2005/067012

(57) **Abstract**

An exposure method for transferring a pattern on a mask onto a substrate using a catadioptric projection optical system having partial lens barrels that hold optical systems having optical axes that extend in mutually different directions. The method includes measuring an amount of rotation of the catadioptric projection optical system about an optical axis intersecting at least one of the mask and the substrate; and adjusting at least one of an attitude and a scan direction of at least one of the mask and the substrate based on a measurement result of the amount of rotation. The substrate is exposed by adjusting at least one of the attitude and the scan direction of at least one of the mask and the substrate so that the rotation of the projected image on the substrate attributable to the rotation of the projection optical system is offset; thus, excellent exposure accuracy is achieved.

## Description

### TECHNICAL FIELD

The present invention relates to an exposure method and apparatus that expose a substrate with a pattern formed on a mask and thus transfer the pattern onto the substrate via a catadioptric projection optical system, and to a device manufacturing method for manufacturing various devices using said method and apparatus.

### BACKGROUND ART

Various devices such as semiconductor devices, liquid crystal display elements, image pickup elements (CCDs (charge coupled devices), etc.), and thin film magnetic heads are manufactured by a technique called photolithography, in which a pattern formed on the reticle as a mask is transferred onto a substrate (a semiconductor wafer or glass plate, etc. which is coated with a resist). Step and repeat system reduction projection exposure apparatuses (so-called steppers) or step and scan system exposure apparatuses are widely employed as the exposure apparatuses used in this photolithography process.

The aforementioned stepper is an exposure apparatus that is mounted on a substrate stage that is able to freely move a substrate two-dimensionally and that step-advances (steps) the substrate using this substrate stage to sequentially repeat the operation of batch exposure of the reduced image of the reticle pattern to the respective shot regions on the substrate. In addition, the step and scan system exposure apparatus is an exposure apparatus that sequentially transfers a portion of a pattern formed on a reticle to the shot regions of a substrate while mutually and simultaneously scanning a reticle stage on which the reticle has been mounted and a substrate stage on which the substrate has been mounted with respect to the projection optical system in a status where slit-shaped pulsed exposure light is being emitted to the reticle and that step-moves the substrate when transfer of the pattern to one shot region has been completed to perform pattern transfer to another shot region.

In recent years, even higher resolutions have been demanded of projection optical systems to handle the ever higher integration of patterns formed on devices. The resolution of a projection optical system is higher the shorter the wavelength of the exposure light used and the larger the numerical aperture of the projection optical system. For this reason, the wavelengths of the exposure light used in the exposure apparatuses are becoming shorter each year, and the numerical apertures of projection optical systems are also increasing. Current mainstream exposure apparatuses are provided with a KrF excimer laser (wavelength of 248 nm) as the light source, but exposure apparatuses that are provided with shorter wavelength ArF excimer lasers (wavelength of 193 nm) are also coming into practical application. In addition, exposure apparatuses that are provided with F₂ lasers (wavelength of 157 nm) or Ar₂ lasers (wavelength of 126 nm) are also being proposed.

In addition, in recent years, liquid immersion type exposure apparatuses are being designed that fill the space between the lower surface of the projection optical system and the substrate surface with a liquid such as water or an organic solvent and increase the numerical aperture of the projection optical system to improve resolution while increasing the depth of focus. With these liquid immersion type exposure apparatuses, it is possible to pursue practical improvement of the numerical aperture of the projection exposure apparatus, but the projection optical system becomes very large in conjunction with the improvement of the numerical aperture. The use of a projection optical system that applies a catadioptric system is considered to be effective in restricting the increase in the size of the projection optical system. Refer to Patent Document 1 below, for example, for details of the aforementioned liquid immersion type exposure apparatus, and refer to Patent Document 2 below for an exposure apparatus that is equipped with a projection optical system that applies a catadioptric system.
Patent Document 1: International Laid-open Patent Publication No. 99/49504 pamphlet
Patent Document 2: Laid-open Japanese Patent Application Publication No. 2002-198280

In any case, refracting system projection optical systems that do not include a reflecting system have one optical axis, but catadioptric system projection optical systems have a plurality of optical axes. Refracting system projection optical systems are such that even if there is rotation about the above optical axis (the optical axis that intersects the substrate), the image projected onto the substrate does not rotate in conjunction with the rotation of the projection optical system. However, catadioptric system projection optical systems that have a plurality of optical axes are such that when there is rotation about an optical axis that intersects the substrate, the image projected onto the substrate also rotates in conjunction with the rotation of the projection optical system.

The projection optical system provided in the exposure apparatus is held on a highly rigid frame, so the projection optical system does not suddenly and largely rotate a great deal in a short period of time. However, there is concern that rotation, though slight, will be produced for such reasons as a drop in frame rigidity over time or movement of the reticle stage provided on the frame. In a catadioptric system projection optical system, when the image projected onto the substrate rotates due to the rotation of the projection optical system, there is a problem in that deterioration of exposure accuracy is caused by distortion of the transferred image formed on the substrate.

### DISCLOSURE OF INVENTION

The present invention was conceived while taking the aforementioned circumstances into account, and its purpose is to provide, in an exposure apparatus having a catadioptric projection optical system, an exposure method and apparatus that are able to expose a substrate with a mask pattern and to transfer the pattern onto the substrate with high exposure accuracy even in the case where the catadioptric projection optical system is rotated about an optical axis that intersects the substrate, as well as a device manufacturing method that manufactures devices using said method and apparatus.

To solve the above problems, an exposure method of the present invention is an exposure method that transfers a pattern on a mask (R) onto a substrate (W) using a catadioptric projection optical system (PL) that has a plurality of partial lens barrels (4, 5) having optical axes (AX1 ~ AX3) that extend in mutually different directions. An amount of rotation of said catadioptric projection optical system about an optical axis (AX3) intersecting at least one of said mask and said substrate is measured, and at least one of the attitude and the scan direction of at least one of said mask and said substrate is adjusted based on the result of the measurement of said rotation amount.

In addition, an exposure method of the present invention is an exposure method that transfers the pattern on said mask onto said substrate while using a catadioptric projection optical system (PL) that has partial lens barrels (4, 5) having optical axes (AX1 ~ AX3) that extend in mutually different directions to scan the mask (R) and the substrate (W). At least one of the attitude and the scan direction of at least one of said mask and said substrate is adjusted according to an amount of rotation of said catadioptric projection optical system about an optical axis (AX3) intersecting at least one of said mask and said substrate.

In addition, an exposure apparatus of the present invention is an exposure apparatus (EX) comprising a catadioptric projection optical system (PL) that has a plurality of partial lens barrels (4, 5) having optical axes (AX1 ~ AX3) that extend in mutually different directions, a mask stage (9) that holds a mask (R), and a substrate stage (16) that holds a substrate (W) and that transfers the pattern on said mask onto said substrate via said catadioptric projection optical system. The apparatus comprises a measuring device (25∼28, 40a ∼ 42a, 40b ∼ 42b, 43a ∼ 43c and 44a ∼ 44c), which measures an amount of rotation of said catadioptric projection optical system about an optical axis (AX3) that intersects at least one of said mask and said substrate, and a control device (30), which adjusts at least one of the attitude and the scan direction of at least one of said mask stage and said substrate stage based on said rotation amount measurement results.

Through these inventions, exposure to the substrate is performed after having adjusted at least one of the attitude and the scan direction of at least one of the mask and the substrate according to the amount of rotation of the catadioptric projection optical system about an optical axis that intersects at least one of the mask and the substrate.

A device manufacturing method of the present invention is characterized in that it includes an exposure step (S26) that performs exposure processing on a substrate using the aforementioned exposure method or exposure apparatus and a development step (S27) that performs development of the substrate that has gone through said exposure process.

Through this invention, the substrate is exposed and developed in a status where at least one of the attitude and the scan direction of at least one of the mask and the substrate has been adjusted based on the measurement results of the amount of rotation of the catadioptric projection optical system about the optical axis.

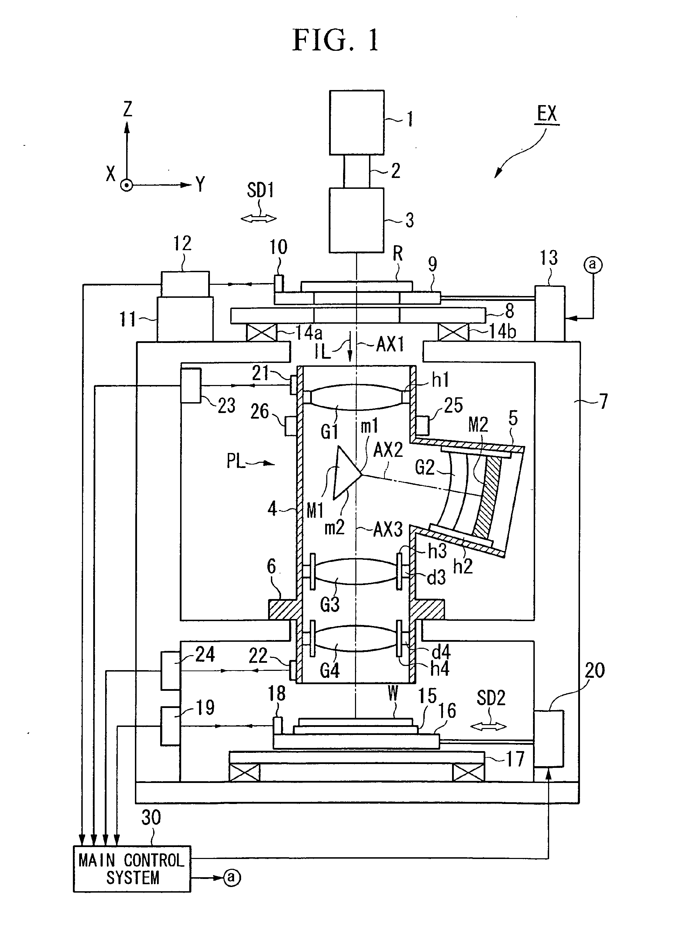

Note that, in the above explanation of the present invention, reference numerals are assigned in parentheses for the respective elements, and they correspond to the configuration of the embodiments shown in Fig. 1 through Fig. 9, but the reference numerals in parentheses assigned to the respective elements are nothing more than examples of those elements, and they do not limit the respective elements.

Through the present invention, the substrate is exposed by adjusting at least one of the attitude and the scan direction of at least one of the mask and the substrate so that the rotation of the projected image on the substrate attributable to the rotation of the projection optical system is offset, so there is an effect such that excellent exposure accuracy (resolution, transfer faithfulness, superimposing accuracy, etc.) can be achieved.

In addition, through the present invention, it is possible to faithfully transfer the mask pattern onto a substrate with high exposure accuracy, so there are effects in that it is possible to manufacture devices on which detailed patterns are formed with high yield, and thus it is possible to reduce device manufacturing costs.

### BRIEF DESCRIPTION OF THE DRAWINGS

Fig. 1 is a drawing that shows the overall configuration of an exposure apparatus according to an embodiment of the present invention.
Fig. 2 is a plan view that shows the attachment positions of fixed mirrors 25 and 26 in the first partial lens barrel 4.
Fig. 3 is a cross-sectional view that shows a projection optical system PL provided on an exposure apparatus according to an embodiment of the present invention.
Fig. 4A is a drawing that explains the method of adjusting the scan direction of the wafer stage 16 in an embodiment of the present invention, Fig. 4B is a drawing that similarly explains the method of adjusting the scan direction of the wafer stage 16, Fig. 4C is a drawing that similarly explains the method of adjusting the scan direction of the wafer stage 16, and Fig. 4D is a drawing that similarly explains the method of adjusting the scan direction of the wafer stage 16.
Fig. 5 is a drawing that explains the method of adjusting the scan direction of the reticle stage 9 in an embodiment of the present invention.
Fig. 6A is a drawing that shows another measurement example of measuring the rotation of the projection optical system PL about the optical axis, Fig. 6B is a drawing that similarly shows the measurement example, and Fig. 6C is a drawing that similarly shows the measurement example.
Fig. 7A is a drawing that shows another measurement example of measuring the rotation of the projection optical system PL about the optical axis, Fig. 7B is a drawing that similarly shows the measurement example, and Fig. 7C is a drawing that similarly shows the measurement example.
Fig. 8 is a flow chart that shows an example of the microdevice manufacturing process.
Fig. 9 is a drawing that shows an example of the detailed flow of step S 13 of Fig. 8 in the case of a semiconductor device.

### BEST MODE FOR CARRYING OUT THE INVENTION

An exposure method and apparatus and a device manufacturing method according to an embodiment of the present invention will be explained in detail below while referring to drawings.

Fig. 1 is a drawing that shows the overall configuration of an exposure apparatus according to an embodiment of the present invention. Note that, in Fig. 1, the illustration integrates a partial cross-sectional view. The exposure apparatus EX of the present embodiment shown in Fig. 1 is a step and scan system exposure apparatus that relatively moves a reticle R as the mask and a wafer W as the substrate in relation to a projection optical system PL in which a catadioptric system is applied while sequentially transferring the pattern formed on the reticle R to the wafer W to fabricate a semiconductor device.

Note that, in the explanation below, if necessary, an XYZ rectangular coordinate system will be set up in the figures, and the positional relationships of the respective elements will be explained while referring to this XYZ rectangular coordinate system. The XYZ rectangular coordinate system is set up so that the X axis and the Y axis are parallel to the wafer W, and the Z axis is set up in a direction that is perpendicular to the wafer W. The XYZ rectangular coordinate system in the figure is such that the XY plane is actually set to a surface that is parallel to the horizontal plane, and the Z axis is set in the vertical direction. In addition, in the present embodiment, the projection optical system PL is incorporated according to the design, and the movement direction of the reticle R (scan direction SD1) and the movement direction of the wafer W (scan direction SD2) during exposure in a status where an amount of rotation about the Z axis is not produced are set to the Y direction (+Y direction, -Y direction).

In Fig. 1, reference numeral 1 indicates a light source for exposure that emits exposure light IL, which is a parallel luminous flux that is approximately rectangular in cross section, and for example, it is an ArF excimer laser light source (wavelength of 193 nm). The exposure light IL, which consists of an ultraviolet pulse signal with a wavelength of 193 nm from the exposure light source 1 passes through a beam matching unit (BMU) 2 and illuminates the pattern surface (lower surface) of the reticle R as the mask via an illumination optical system 3. The illumination optical system 3 has an optical integrator, the aperture stop (σ stop) of the illumination system, a relay lens system, a field stop (reticle blind), and a condenser lens system. The beam matching unit 2 and the illumination optical system 3 are respectively stored in highly airtight subchambers (not shown in the drawing).

The exposure light IL that has passed through the reticle R forms the image of the pattern of that reticle R on the wafer W as the substrate via a projection optical system PL having a catadioptric system. The wafer W is, for example, a disk-shaped substrate such as a semiconductor (silicon, etc.) or SOI (silicon on insulator), and the surface of the wafer W is coated with photoresist (photosensitive material). The projection optical system PL is formed by including a first lens group G1, which has the first optical axis AX1 as its optical axis, a reflecting mirror block M1 on whose surfaces two plane reflecting mirrors (reflective surfaces) m1, m2 are formed, lens group G2 and concave mirror M2, which have the second optical axis AX2 that intersects the first optical axis AX1, as their optical axis, and a second lens group G3 and third lens group G4, which have the third optical axis AX3, which intersects the second optical axis AX2, as their optical axis.

After the image forming luminous flux from the reticle R has passed through the first lens group G1, it is reflected by the plane reflecting mirror m1 formed on the reflecting mirror block M1 then passes through the second lens group G2 and reaches the concave mirror M2. Then, it is reflected by the concave mirror M2 and again passes through the second lens group G2 to reach the plane reflecting mirror m2 formed on the reflecting mirror block M1. The image forming luminous flux reflected by the plane reflecting mirror m2 continues on to pass through the third lens group G3 and the fourth lens group G4 in sequence and forms the projected image of the pattern of the reticle R on the wafer W. The image forming magnification of the projection optical system PL from the reticle R to the wafer W is a reduction magnification of approximately 1/4~ 1/5 times, and the interior of the projection optical system PL is also made airtight.

In the projection optical system PL, the first lens group G1, the reflecting mirror block M1, the third lens group G3 and the fourth lens group G4 are held in common by the first partial lens barrel 4. In the present embodiment, the first optical axis AX1 of the first lens group G1 is set to be perpendicular to the pattern surface (reticle surface) of the reticle R, the third optical axis AX3 of the third lens group G3 and the fourth lens group G4 is set to be perpendicular to the exposure surface (wafer surface) of the wafer W, and the first optical axis AX1 and the third optical axis AX3 become the same axis. Also, the wafer surface is a nearly horizontal surface, and the first optical axis AX1 and the third optical axis AX3 extend in the vertical direction (the direction parallel to the Z axis). However, the first optical axis AX1 and the third optical axis AX3 do not necessarily need to be the same axis. In addition, the first lens group G1 is held by the first partial lens barrel 4 by means of a holding mechanism h1, the third lens group G3 is held by the first partial lens barrel 4 via a holding mechanism h3 and a position adjustment mechanism d3, and the fourth lens group G4 is held by the first partial lens barrel 4 via a holding mechanism h4 and a position adjustment mechanism d4.

On the other hand, the second lens group G2 and the concave mirror M2 that have the second optical axis AX2 as their optical axis are held by the second partial lens barrel 5 via a holding mechanism h2, and the second partial lens barrel 5 mechanically connects with the first partial lens barrel 4 by means of a linking member that is not shown in the drawing. In addition, a flange part provided on the first partial lens barrel 4 is installed through an opening provided on the main body frame 7 (to be discussed below) via a mount part 6. That is, the projection optical system PL is entirely supported by the main body frame 7, and the second partial lens barrel 5 is supported by the first partial lens barrel 4 within the projection optical system PL.

The exposure main body part that transfers the pattern of the reticle R onto the wafer W, from among the portions that form the exposure apparatus EX of the present embodiment, is entirely supported within the box-shaped main body frame 7. In addition, the reticle R is held on the reticle stage 9, which is mounted on a reticle base 8 so that scanning in the Y direction is possible. The two-dimensional position information and rotation information of the reticle stage 9 are measured by a movable mirror 10 (in actuality, there are two axis portions, for the X axis and the Y axis. The same applies hereunder.) on the reticle stage 9 and a laser interferometer 12 that is correspondingly arranged on a pedestal 11 on the main body frame 7, and this measurement value is supplied to a main control system 30 that controls the operation of the entire apparatus. Based on the measurement value from the laser interferometer 12 and the control information from the main control system 30, a reticle stage control system 13 controls position of the reticle stage 9 in the X direction and the Y direction and its rotation about the Z axis and velocity and further adjusts the scan direction of the reticle stage 9 to correspond to the control signals of the main control system 30.

A reticle stage system is formed from a reticle base 8, a reticle stage 9 and the drive mechanisms thereof (not shown in the drawing), and the reticle base 8 is supported on the main body frame 7 via active vibration damping mechanisms 14a, 14b, (in actuality, they are arranged in three locations, for example). The active vibration damping mechanisms 14a, 14b are mechanisms formed by combining an air damper and an electromagnetic actuator (voice coil motor, etc.) that block high frequency vibration using the air damper and inhibit the transmission of vibration in a broad frequency range by producing vibration from the actuator to offset low frequency vibration. The vibration produced by scanning the reticle stage 9 is prevented from being transmitted to the main body frame 7 by the active vibration damping mechanisms 14a, 14b.

The wafer W is held on the wafer stage (Z leveling stage) 16 via a wafer holder 15. The wafer stage 16 is mounted on a wafer base 17 so that scanning in the Y direction is possible and so that step movement in the X direction and the Y direction is possible. Two dimensional position information and rotation information of the wafer stage 16 are measured by a movable mirror 18 on the wafer stage 16 and a laser interferometer 19 correspondingly arranged within the main body frame 7, and these measurement values are supplied to the main control system 30.

Based on the measurement values of the laser interferometer 19 and the control information from the main control system 30, a wafer stage control system 20 controls the position of the wafer stage 16 in the X direction and the Y direction and its rotation about the Z axis and velocity, and the scan direction of the wafer stage 16 is further adjusted according to the control signals of the main control system 30. In addition, the focus position and the angle of inclination about the X axis and the Y axis of the wafer W are controlled by the wafer stage 16 by using a servo system so that the surface of the wafer W during exposure is focused onto the image plane of the projection optical system PL based on the information of the focus positions (positions in the Z direction) at a plurality of measurement points of the surface of the wafer W from an autofocus sensor (optical sensor in a grazing incidence system) not shown in the drawing.

In addition, fixed mirrors 21, 22 are respectively attached (in actuality, there are respectively two axis portions, for the X axis and the Y axis) to the upper end side surface and the lower end side surface of the projection optical system PL, and the positions of the fixed mirrors 21, 22 are respectively measured by laser interferometers 23, 24 installed within the main body frame 7, and the measurement values thereof are supplied to the main control system 30. Based on these measurement values, the main control system 30 obtains the position and inclination (the tilt angle about the X axis and the Y axis) of the projection optical system PL in the X direction and the Y direction. The positions of the reticle stage 9 and the wafer stage 16 are corrected according to the positions of the fixed mirrors 21, 22, that is, the position of the projection optical system PL.

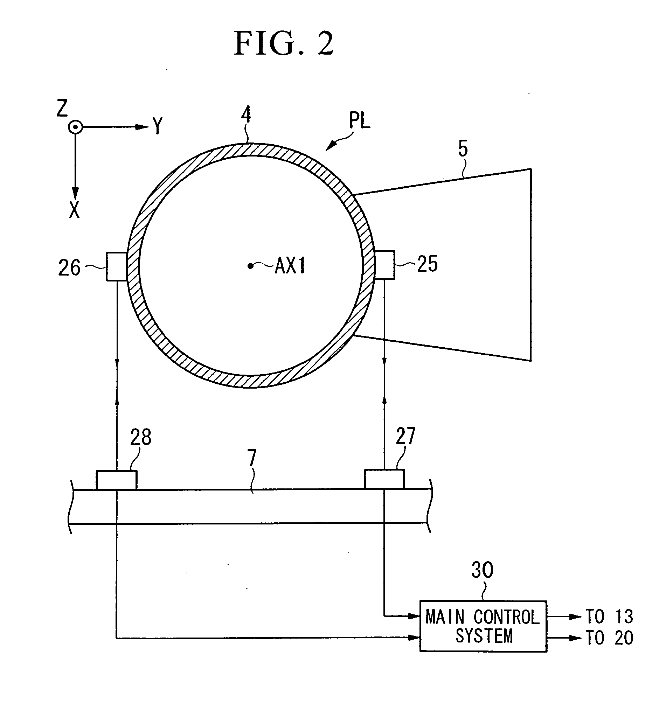

In addition, fixed mirrors 25, 26 for measuring the amount of rotation of the projection optical system PL about the first optical axis AX1 and the third optical axis AX3 are attached to the first partial lens barrel 4 of the projection optical system PL. Fig. 2 is a plan view that shows the attachment positions of the fixed mirrors 25, 26 in the first partial lens barrel 4. As shown in Fig. 2, the fixed mirrors 25, 26 are paired to interpose the first optical axis AX1 and are attached to the first partial lens barrel 4. In the examples shown in Fig. 1 and Fig. 2, fixed mirror 25 is attached in the vicinity of the attachment base part of the first partial lens barrel 4 and the second partial lens barrel 5, and fixed mirror 26 is attached at a position that is symmetrical with the attachment position of the fixed mirror 25 in relation to the first optical axis AX1.

Laser light beams from the laser interferometers 27, 28 attached to the main body frame 7 are respectively emitted to these fixed mirrors 25, 26 in the -X direction, and the laser light beams that have been respectively reflected in the +X direction by the fixed mirrors 25, 26 are respectively received by the laser interferometers 27, 28, the respective positions of the fixed mirrors 25, 26 in the X direction are measured, and these measurement values are supplied to the main control system 30. The main control system 30 obtains the amount of rotation of the projection optical system PL about the first optical axis AX1 (i.e., the third optical axis AX3) from the difference in the measurement values of the laser interferometers 27, 28 and adjusts the scan direction of the wafer stage 16 according to this amount of rotation.

In an exposure apparatus EX with the above configuration, when the wafer W is exposed, exposure light IL is emitted to the reticle R, and the operation of simultaneously moving the reticle R and the wafer W in the Y direction with the image formation magnification of the projection optical system PL as the velocity ratio is performed in a status in which a portion of the pattern image formed on the reticle R is projected onto one shot region on the wafer W via the projection optical system PL. In addition, when there is movement from the shot region where exposure has been completed to the next shot region where exposure is to be performed, an operation is performed in which the wafer W is step-moved in a status in which exposure light IL is not being emitted to the reticle R. These operations, that is, the step and scan operations, are repeated, and the pattern image of the reticle R is transferred to the respective shot regions on the wafer W.

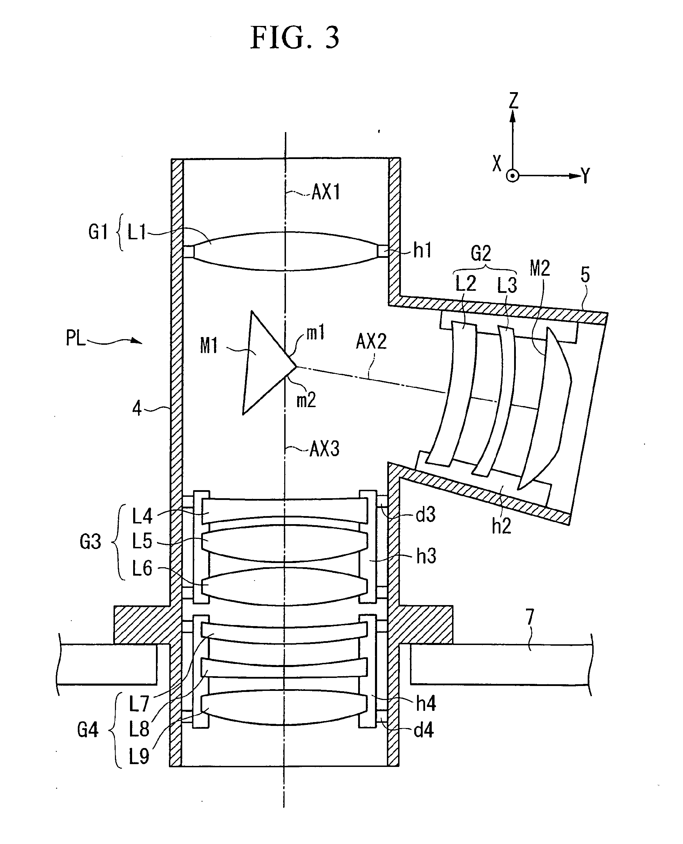

Here, an example of the lens configuration of the projection optical system PL provided on the exposure apparatus EX of the present embodiment will be explained. Fig. 3 is a cross-sectional view that shows a detailed configuration example of the projection optical system PL provided on an exposure apparatus of an embodiment of the present invention. In the example shown in Fig. 3, in the first partial lens barrel 4, the first lens group G 1 has one lens L1, the third lens group G3 has lenses L4 ∼ L6, and the fourth lens group G4 has lenses L7 ~ L9. In addition, the second lens group G2 in the second partial lens barrel 5 has lenses L2 and L3. The lenses L4 ∼ L6 are held within a common holding mechanism h3, the holding mechanism h3 is held within the first partial lens barrel 4 via position adjustment mechanisms d3 at a plurality of locations, the lenses L7 ~ L9 are held within a common holding mechanism h4, and the holding mechanism h4 is held within the first partial lens barrel 4 via position adjustment mechanisms d4 at a plurality of locations. Note that the first through fourth lens groups G1, G2, G3, G4 may be respectively formed by one optical element or a plurality of optical elements.

Here, if a shot region on the wafer W is to be exposed, the position of the projection optical system PL within the XY plane is measured according to the measurement results of the laser interferometers 23, 24, and after the positions of the reticle stage 9 and the wafer stage 16 within the XY plane with respect to the projection optical system PL have been corrected based on these measurement results, these stages are scanned in scan directions SD1 and SD2, and the pattern of the reticle R is transferred onto the wafer W. In an exposure apparatus that is equipped with a conventional projection optical system having a refracting system as well, the same type of correction is performed during exposure, but in the case of a refracting system projection optical system, the projected image resulting from the projection optical system does not rotate in conjunction with the rotation of the projection optical system even if the projection optical system rotates about the optical axis. For this reason, it was possible to transfer the pattern in the reticle to the prescribed position on the wafer even if the scan direction was not adjusted according to the rotation of the projection optical system PL.

However, if a catadioptric system projection optical system PL is provided as in the exposure apparatus EX of the present embodiment, the projected image from the projection optical system rotates in conjunction with the rotation of the projection optical system PL (rotation about the first optical axis AX1 and the third optical axis AX3). In a status in which the projection optical system PL has been rotated, even though the positions of the reticle stage 9 and the wafer stage 16 within the XY plane with respect to the projection optical system PL are corrected and it is possible to align the center of the projected image to the center of the shot region subjected to exposure, an error resulting from rotation is produced in the vicinity of the outer circumference of the shot region, and exposure accuracy drops. The rotation of the projection optical system PL is produced by such factors as changes over time in the main body frame 7 resulting from changes in the environment where the exposure apparatus EX is installed (for example, atmospheric temperature or humidity).

In addition, the movable members (vibration sources), which are the reticle stage 9 and the wafer stage 16, are separated so that vibration is not transmitted to the main body frame 7 where the projection optical system PL is held by means of the active vibration damping mechanisms 14a, 14b, but, even so, the transmission of slight vibrations to the main body frame 7 causing the projection optical system PL to vibrate cannot be avoided. Particularly in the case of the present embodiment, in which the projection optical system PL is a catadioptric system, the structure of the lens barrel is complex, so there is a possibility of it being easily vibrated by slight vibrations from external forces. If the period of this vibration is longer than the prescribed exposure time (image transfer time) of one point on the wafer W, for example, approximately 100 msec, a problem occurs whereby the image position is dislocated due to that vibration, and if the period of the vibration is shorter than the aforementioned exposure time, a problem occurs whereby the sharpness of the image drops due to that vibration.

In the present embodiment, the above problems generated by the rotation of the projection optical system PL are solved by the following methods. Specifically, as shown in Fig. 2, two fixed mirrors 25, 26 are attached to the first partial lens barrel 4 so as to interpose the first optical axis AX1, the distance between laser interferometer 27 and fixed mirror 25 and the distance between laser interferometer 28 and fixed mirror 26 are measured, these measurement values are supplied to the main control system 30, and the amount of rotation of the projection optical system PL about the first optical axis AX1 is obtained from the difference between these. The amount of rotation of the projected image with respect to the amount of rotation of the projection optical system PL about the first optical axis AX1 can be determined by means of calculation based on the design data in the computation part of the main control system 30 or a table (or approximation expression, etc.) obtained in advance experiments.

Therefore, the main control system 30 calculates the amount of rotation of the projected image on the wafer W according to the amount of rotation of the projection optical system PL obtained from the measurement results of the laser interferometers 27, 28 as it calculates the amount of correction of the wafer stage 16 in scan direction SD2 to offset that rotation of that projected image. The calculated amount of correction is supplied to the wafer stage control system 20, and the scan direction SD2 of the wafer stage 16 is adjusted in accordance with the amount of correction. Therefore, when the projection optical system PL rotates, scan direction SD1 of the reticle stage 9 is the Y direction, but scan direction SD2 of the wafer stage 16 becomes misaligned from the Y direction according to the amount of rotation of the projected image resulting from the rotation of the projection optical system PL. Specifically, scan direction SD2 of the wafer stage 16 is shifted by a prescribed angle with respect to the Y direction according to the amount of rotation of the projected image. Due to the relevant adjustment, exposure is performed while the wafer stage 16 is scanned in scan direction SD2 which has been adjusted to a direction in which the rotation of the projected image produced due to the rotation of the projection optical system PL is offset.

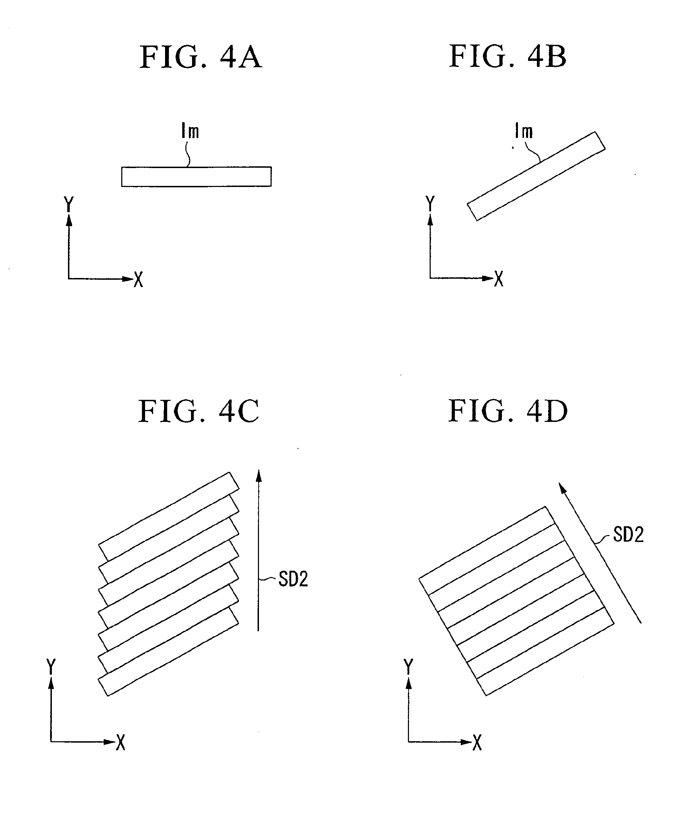

Figs. 4A through 4D are drawings that explain the method of adjusting the scan direction of the wafer stage 16 in one embodiment of the present invention. First, if rotation of the projection optical system PL is not produced, as shown in Fig. 4A, the projected image that is projected onto the wafer W becomes a slit-shaped projected image Im that extends in the X direction. In contrast with this, if rotation of the projection optical system PL is produced, as shown in Fig. 4B for example, the projected image Im that is projected onto the wafer W goes into a status in which the projected image Im shown in Fig. 4A is rotated according to the amount of rotation of the projection optical system PL in the XY plane. Note that, in the example shown in Fig. 4B, an example of a case where the rotation direction of the amount of rotation of the projected image Im is a direction from the X axis to the Y axis is depicted, and that amount of rotation is depicted in an exaggerated manner.

In a status in which the projected image Im has been rotated as shown in Fig. 4B, when the reticle stage 9 and the wafer stage 16 are moved in the Y direction (scan directions SD1 and SD2 are both set to the Y direction) without performing adjustment of scan direction SD2 of the wafer stage 16, the wafer W is exposed as shown in Fig. 4C. Specifically, the wafer W is exposed in a status where the projected image Im in a rotated status is moved in the Y direction on the wafer W. Note that, in Fig. 4C, in order to facilitate comprehension, projected images in a rotated form are depicted adjacently, but, in actuality, the wafer W is continuously exposed, so the region exposed by one scan is a parallelogram, and a pattern similar to the pattern on the reticle R is not transferred onto the wafer W. That is, the transferred image of the reticle R to be formed in a rectangular shape is distorted into a parallelogram and formed on the wafer W.

In contrast with this, after scan direction SD2 of the wafer stage 16 has been adjusted in the direction in which the rotation of the projected image Im is offset (the rotation direction of the projected image Im), when exposure is performed while respectively moving the reticle stage 9 in scan direction SD1 (the Y direction) and the wafer stage 16 in scan direction SD2, as shown in Fig. 4D, the region exposed on the wafer W becomes a rectangular shape, and a pattern that is similar to the pattern of the reticle R is transferred. Through this, it is possible to prevent causing deterioration of the image formation characteristics and the exposure accuracy (transfer faithfulness, superimposing accuracy, etc.) of the transferred image resulting from rotation of the projection optical system PL.

Note that a pattern similar to the pattern of the reticle R can be transferred onto the wafer W simply by adjusting scan direction SD2 of the wafer stage 16, but to increase the superimposing accuracy with the pattern already formed on the wafer W, it is desirable that exposure processing be performed by rotating the wafer stage 16 within the XY plane by the same amount as the amount of rotation of the projected image Im. In addition, in the case where superimposing with the pattern already formed in the wafer W is to be performed, it is preferable that adjustment of scan direction SD2 of the wafer stage 16 be performed while taking into account not only the amount of rotation of the pattern image Im but also the distortion of the pattern already formed on the wafer W. Note that in the case where there is tilting of the projection optical system PL (tilt angle about the X axis and the Y axis) in addition to rotation of the projection optical system PL, when the wafer stage 16 is moved in the adjusted scan direction SD, control that performs movement while changing the position of the wafer stage 16 in the Z direction according to the tilt of the projection optical system PL is performed.

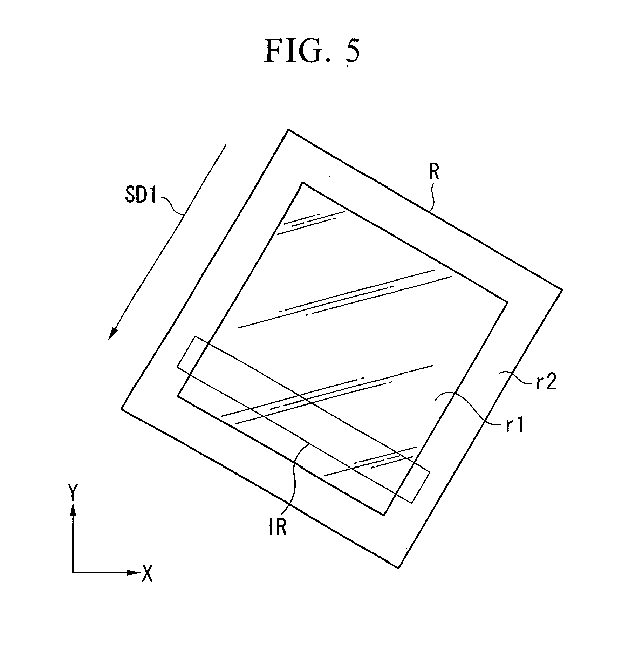

In the above explanation, scan direction SD2 of the wafer stage 16 was adjusted to offset the rotation of the projected image resulting from rotation of the projection optical system PL, but it is also possible to offset the rotation of the projected image by adjusting scan direction SD1 of the reticle stage 9. Fig. 5 is a drawing that explains the method of adjusting the scan direction of the reticle stage 9 in an embodiment of the present invention. Fig. 5 shows the upper surface of the reticle R, and provided on the reticle R are a light transmission region r1 through which the exposure light IL passes and a light cutoff region r2 that cuts off unnecessary exposure light IL. A metal such as chrome (Cr) is deposited on an outer circumference part of the lower surface of the reticle R (the surface that faces the projection optical system PL), the region where this chrome is deposited becomes the light cutoff region r2, and the other region becomes the light transmission region r1.

The pattern to be transferred onto the wafer W is formed on the light transmission region r1 on the lower surface of the reticle R.

To correct the rotation of the projected image resulting from rotation of the projection optical system PL, as shown in Fig. 5, the illumination region IR of the illumination light IL with respect to the reticle R is rotated by an amount equivalent to the amount of rotation of the projected image in a direction opposite to the rotation direction of the projected image (i.e., the direction from the x axis to the y axis). Rotation of the illumination region IR is performed by rotating a field stop (reticle blind) that is not shown in the drawing included in the illumination optical system 3 for example. In addition, as shown in Fig. 5, scan direction SD1 of the reticle stage 9 is adjusted while rotating the reticle R by an amount equivalent to the amount of rotation of the illumination region IR in a direction opposite to the rotation direction of the projected image to match the rotation of the illumination region IR.

After the aforementioned adjustment has been performed, when exposure is performed while respectively moving the reticle stage 9 in scan direction SD1 shown in Fig. 5 and the wafer stage 16 in scan direction SD2 (the Y direction) without causing rotation within the XY plane, a pattern that is similar to the pattern formed on the reticle R is transferred onto the wafer W. Through this, it is possible to prevent the image formation characteristics and the exposure accuracy (transfer faithfulness, superimposing accuracy, etc.) of the transferred image from deteriorating due to rotation of the projection optical system PL.

Note that measurement of the amount of rotation of the projected image resulting from rotation of the projection optical system PL is performed at prescribed intervals. For example, rotation produced by changes in the main body frame 7 over time is measured twice a day, daily or monthly. In addition, rotation produced by movement of the reticle stage 9, for example, is always being measured. In the case of the latter, exposure is performed while adjusting the scan direction of the wafer stage 16 for each shot region formed on the wafer W for example. Note that, in the case of the latter, measurement of the amount of rotation by acceleration sensors may be performed instead of measurement of the amount of rotation of the projection optical system PL using laser interferometers 27, 28.

If measurement of the amount of rotation is performed by acceleration sensors, the velocity is obtained by time integration by inputting the detection results of the acceleration sensors attached to the projection optical system PL to a computation part which the main control system 30 is provided with, and the amount of movement of the projection optical system PL is computed by further time-integrating the velocity. It is possible to obtain the amount of rotation of the projection optical system PL by using the amounts of movement at the respective attachment positions obtained from the detection results of the acceleration sensors attached to a plurality of parts of the projection optical system PL.

The acceleration sensors are attached at the positions of the fixed mirrors 25, 26 in Fig. 2 for example. Movement resulting from rotation of the projection optical system PL becomes larger the further the location is from the first optical axis AX1 and the third optical axis AX3. For this reason, it is preferable that at least one of the acceleration sensors be attached to the second partial lens barrel 5 (for example, in the vicinity of the concave mirror M2). When the amount of rotation of the projection optical system PL is obtained using acceleration sensors, exposure processing is performed after adjustment of scan direction SD2 of the wafer stage 16 or adjustment of scan direction SD1 of the reticle stage 9 has been performed by a method similar to the aforementioned method.

Note that, in the above explanation, the case where only scan direction SD2 of the wafer stage 16 was adjusted or the case where only scan direction SD1 of the reticle stage 9 was adjusted was explained, but it is also permissible to perform both adjustment of scan direction SD2 of the

wafer stage 16 and scan direction SD1 of the reticle stage 9. For example, it may be such that adjustment of scan direction SD2 of the wafer stage 16 is performed so that half of the amount of rotation of the projected image resulting from rotation of the projection optical system PL is offset and adjustment of scan direction SD1 of the reticle stage 9 is performed so that the remaining amount of rotation is offset. The relevant adjustments are effective in the case where it is not possible to offset the full amount of rotation of the projected image with either one of the adjustments.

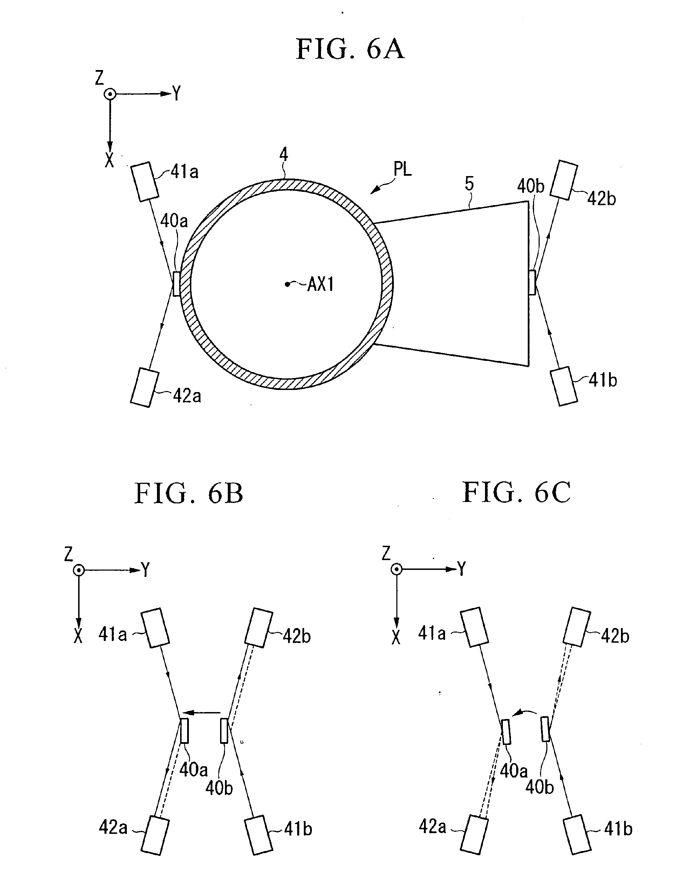

In addition, in the above embodiment, the fixed mirrors 25, 26 and the laser interferometers 27, 28 attached to the first partial lens barrel 4 symmetrically in relation to the first optical axis AX1 were used to measure the rotation of the projection optical system PL about the first optical axis AX1 (the third optical axis AX3), but the rotation of the projection optical system PL may also be measured using fixed mirrors and laser interferometers attached to the second partial lens barrel 5. Figs. 6A ∼ 6C are drawings that show another measurement example of measurement of the rotation of the projection optical system PL about the optical axis. As shown in Fig. 6A, one fixed mirror 40a is attached to the first partial lens barrel 4, and another fixed mirror 40b is attached to the second partial lens barrel 5. The fixed mirror 40b is attached to a part that is farthest from the first optical axis AX1 of the second partial lens barrel 5, and it is not arranged symmetrically with the fixed mirror 40a in relation to the first optical axis AX1.

Provided on one fixed mirror 40a are an emission part 41a that emits a detection beam from a diagonal direction with respect to the fixed mirror 40a and a light receiving part 42a that receives the detection beam reflected by the fixed mirror 40a. In the same way, provided on the other fixed mirror 40b are an emission part 41b that emits a detection beam from a diagonal direction with respect to the fixed mirror 40b and a light receiving part 42b that receives the detection beam reflected by the fixed mirror 40b. The light receiving parts 42a, 42b have two dimensional image pickup elements such as two dimensional CCDs and detect the positions of incidence of the detection beams.

In the above configuration, the detection positions of the detection beams at the light receiving parts 42a and 42b respectively do not change in the case where the projection optical system PL moves in parallel to the X direction. In contrast with this, if we consider the case where the projection optical system PL moves in parallel to the -Y direction as shown in Fig. 6B, the fixed mirrors 40a, 40b move in the-Y direction in conjunction with the movement of the projection optical system PL. For this reason, the positions of incidence of the detection beams from the respective emission parts 41 a, 41 b change, and as a result the detection beams reflected from the fixed mirrors 40a, 40b are incident to the light receiving parts 42a and 42b respectively after going along optical paths different from the optical paths which are followed in the case where there is no positional dislocation of the projection optical system PL to the-Y direction (i.e., the optical paths shown by the dashed lines in Fig. 6B).

In addition, if we consider the case where the projection optical system PL has rotated in a direction from the X axis to the Y axis about the first optical axis AX1 as shown in Fig. 6C, the fixed mirrors 40a, 40b also rotate about the first optical axis AX1 to match the rotation of the projection optical system PL. When the relevant rotation is produced, the angle of incidence of the detection beam from the emission part 41a with respect to the fixed mirror 40a and the angle of incidence of the detection beam from emission part 41b with respect to the fixed mirror 40b both become larger. As a result, the reflection angles of the detection beams also become larger, and the detection beams reflected by the fixed mirrors 40a, 40b advance toward directions that are different from the optical paths followed in the case where there is no rotation of the projection optical system PL (see the optical paths shown by the dashed lines in Fig. 6C) and are respectively incident to the light receiving parts 42a and 42b.

The detection results of the positions of incidence of the detection beams in the light receiving parts 42a and 42b are output to the main control system 30. Here, when Fig. 6B and Fig. 6C are compared, the position of incidence of the detection beam with respect to the light receiving part 42b changes in the same way in the case where the projection optical system PL has moved in parallel to the Y direction and the case where the projection optical system PL has rotated. However, the position of incidence of the detection beam with respect to the light receiving part 42a changes differently for either case. Therefore, it is possible to obtain the amount of movement of the projection optical system PL in the Y direction and the amount of rotation of the projection optical system PL using the detection result of the light receiving part 42a and the detection result of the light receiving part 42b.

In the case where the amount of movement of the projection optical system PL in the Y direction and the amount of rotation of the projection optical system PL cannot be clearly distinguished using only the detection results of the light receiving parts 42a and 42b, it is possible to obtain the amount of rotation of the projection optical system PL by using the position of the projection optical system PL in the Y direction detected by the laser interferometers 23 and 24. In addition, in the case where the detection results of the laser interferometers 23 and 24 are used, it is possible to obtain the amount of rotation of the projection optical system PL from the detection results of the light receiving part 42b and the detection results of the laser interferometers 23 and 24 while omitting the fixed mirror 40a, the emission part 41a and the light receiving part 42a and using only the fixed mirror 40b, the emission part 41 b and the light receiving part 42b.

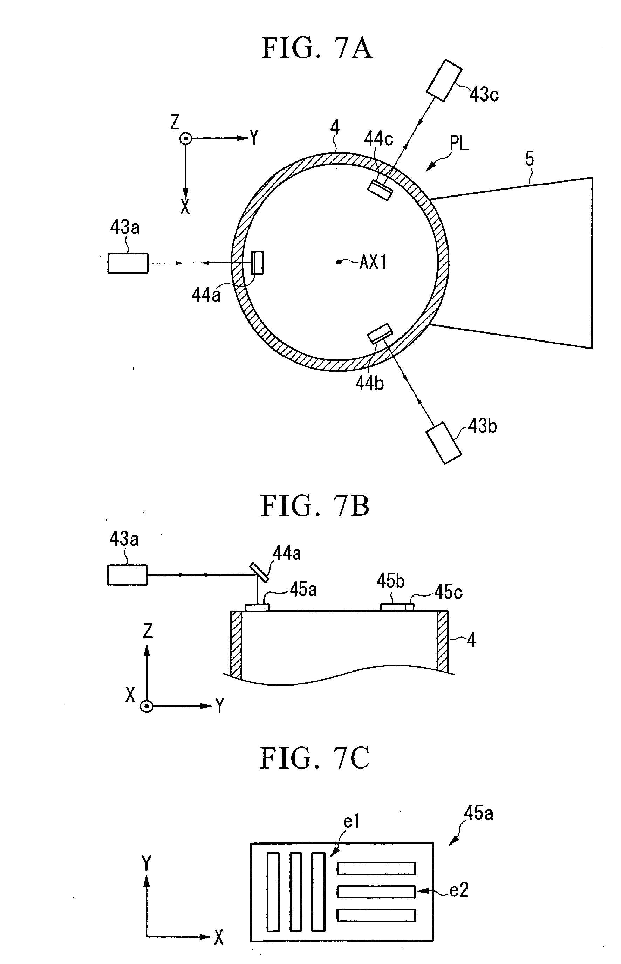

In addition, the amount of rotation of the projection optical system PL can also be obtained by observing position detection marks attached to the projection optical system PL. Figs. 7A ~ 7C are drawings that show another measurement example that measures the rotation of the projection optical system PL about the optical axis. As shown in Fig. 7B, it is the upper end (the reticle R side end part) of the first partial lens barrel 4, and three position detection marks 45a ∼ 45c are attached at positions at which the exposure light IL is not cut off at 120° intervals to each other centering on the first optical axis AX1.

In addition, as shown in Fig. 7A and 7B, reflecting mirrors 44a ∼ 44c are respectively provided above (+Z direction) the marks 45a ∼ 45c, and observation parts 43a ~ 43c for observing the marks 45a ∼ 45c respectively via these reflecting mirrors 44a ∼ 44c are further provided. The observation part 43a is configured so as to include a light source such as a halogen lamp, a two-dimensional image pickup element such as a CCD, and a position information computation part that obtains the position information of the mark 45a by performing image processing of image signals obtained by the image pickup element.

When the position information of the mark 45a is obtained, light is emitted to the reflecting mirror 44a from the light source of the observation part 43a, this light is reflected by the reflecting mirror 44a and illuminates the mark 45a, and the light that has been reflected by the mark 45a and has come via the reflecting mirror 44a is picked up by the image pickup element. Then, the position information of the mark 45a is calculated by performing image-processing of the obtained image signal by the position information computation part. Note that the observation parts 43b and 43c have the same configuration as the observation part 43a, so an explanation thereof will be omitted here.

As shown in Fig. 7C for example, the mark 45a consists of a first mark e1, in which mark elements that extend in the Y direction are arrayed in the X direction, and a second mark e2, in which mark elements that extend in the X direction are arrayed in the Y direction. Note that the marks 45b and 45c have the same configuration as the mark 45a, but the mark 45b is attached in a status in which the mark 45a has been rotated 120° in a direction from the X axis to the Y axis, and the mark 45c is attached in a status in which the mark 45a has been rotated 240° in a direction from the X axis to the Y axis.

The respective position information computation parts of the observation parts 43a ∼ 43c obtain the position information of the marks 45a ∼ 45c by performing, on the image signals output from the respectively provided image pickup elements, mark position measurement processing such as cyclical autocorrelation processing, template matching processing using a prescribed template, or edge position measurement processing (processing that obtains a profile of each mark, processing that detects the respective edge positions of the mark elements that form each mark from the obtained profile, and processing that obtains the center of the first mark e1 and the center of the second mark e2 from the detected edge positions). In the case of the mark 45a, the position information in the X direction is obtained from the first mark e1, and the position information in the Y direction is obtained from the second mark e2.

The position information of the marks 45a ∼ 45c respectively obtained by the observation parts 43a ∼ 43c is output to the main control system 30, and the amount of rotation of the projection optical system PL is calculated by the computation part of the main control system 30. Note that, in Figs. 7A ~ 7C, the case in which all of marks 45a ∼ 45c are attached to the first partial lens barrel 4 was explained as an example, but the marks may also be attached to the second partial lens barrel 5. In the case where the marks are attached to the second partial lens barrel 5, in the same way as the case in which acceleration sensors are attached, it is preferable that they be attached to the front end part (for example, in the vicinity of the concave mirror M2) of the second partial lens barrel 5. In addition, in Figs. 7A ~ 7C, the case in which three marks were attached was given as an example, but two or more marks may be attached to the projection optical system.

Note that, in the case where the amount of rotation of the projection optical system PL is measured in the above way to obtain the amount of rotation of the projected image, it is necessary to make clear in advance the relationship between the amount of rotation of the projection optical system PL and the amount of rotation of the projected image. This relationship can be theoretically calculated from the optical design data and the mechanical design data, so it is possible to adjust scan direction SD1 of the reticle stage 9 and scan direction SD2 of the wafer stage 16 according to these theoretical values. In addition, it is also possible to measure the relationship between the amount of rotation of the projection optical system PL and the amount of rotation of the projected image based on advance experiments and to store these measurement results in the form of a table or an approximation.

For example, in a status in which a sensor capable of position measurement, such as an image pickup element and a knife edge sensor, is arranged at the arrangement position (i.e., the image plane) of the wafer W and the projected image of the reticle pattern has been projected onto the sensor, it is possible to experimentally obtain that relationship between the amount of rotation of the projection optical system PL and the amount of rotation of the projected image by gradually rotating the projection optical system PL by a prescribed amount (for each rotation) about the first optical axis AX1 (the third optical axis AX3) and measuring the positional dislocation (for each rotation) of that projected image by using the sensor.

Note that, in the above embodiment, the case in which the first lens group G1, the third lens group G3 and the fourth lens group G4 are held by the same first partial lens barrel 4 and measurement of the amount of rotation about the first partial lens barrel 4 is performed was explained as an example. However, it is also possible to apply the present invention to a projection optical system PL with a configuration in which the respective lens groups G1, G3, G4 are respectively held by separate partial lens barrels for example. For a projection optical system PL with the relevant configuration, it is possible to measure the amount of rotation with higher accuracy by simultaneously measuring the amounts of rotation of two or three partial lens barrels.

Note that, in the above embodiment, the amount of rotation of the projection optical system PL is measured and the scan directions of the reticle R and the wafer W are adjusted based on those measurement results, but in the case where it is possible to predict the changes over time in the amount of rotation of the projection optical system PL through experimentation or simulation, adjustment of the scan direction of the reticle R and the wafer W may be performed based on the predicted value of the amount of rotation of the projection optical system PL without performing measurement of the amount of rotation of the projection optical system PL.

In addition, in the above embodiment, the plane reflecting mirrors m1, m2 are formed as a unit on one member (reflecting mirror block M1), but the two reflecting mirrors m1, m2 may also be formed on separate members. However, forming two reflecting mirrors m1, m2 as a unit is, of course, advantageous on the points of ease of adjustment and stability.

In addition, the second lens group G2 and the concave mirror M2 have been included in the second partial lens barrel 5 of the projection optical system PL indicated in the above embodiment, but the present invention may be applied even if it is a partial lens barrel that includes only a concave mirror or a partial lens barrel that includes only a lens. In addition, the projection optical system PL of the above embodiment has two partial lens barrels having optical axes that extend in mutually different directions, but the present invention can also be applied to projection optical systems having three or more partial lens barrels having optical axes that extend in mutually different directions. In addition, the present invention can also be applied to the case where a catadioptric projection optical system is used as the projection optical system, which has an optical system having an optical axis extending from the reticle R to the wafer W and has a catadioptric optical system having an optical axis that is nearly perpendicular to the above optical axis, so as to form two intermediate images in the interior.

An embodiment of the present invention was explained above, but the present invention is not limited to the above embodiment, and changes may be made freely within the scope of the present invention. For example, in the above embodiment, a step and scan system exposure apparatus was explained, but the present invention may also be applied to a step and repeat system exposure apparatus. In the case of a step and repeat system exposure apparatus, since the entire projected image of the projection optical system PL is rotated within the XY plane due to the rotation of the projection optical system PL, exposure may be performed in a status where the wafer stage is rotated within the XY plane so that the rotation of the projected image is offset to adjust the attitude of the wafer stage. In addition, the attitude of the reticle stage may be adjusted instead of the attitude of the wafer stage, and both the attitudes of the reticle stage and the wafer stage may be adjusted.

Note that, in the above embodiment, the case in which an ARF excimer laser (wavelength of 193 nm) is provided as the exposure light source 1 was explained, but it is also possible to use a KrF excimer laser (wavelength of 248 nm), an F₂ laser (fluorine laser: wavelength of 157 nm), a Kr₂ laser (krypton dimer laser: wavelength of 146 nm), or an Ar₂ laser (argon dimer laser: wavelength of 126 nm). In addition, it is also possible to use a light source that is effectively in a vacuum ultraviolet range such as a YAG laser higher-harmonics generation apparatus or a semiconductor laser higher-harmonics generation apparatus. In addition, the present invention can be applied when the structure of the projection optical system is complex as is the case with a catadioptric system even in the case where exposure light with the wavelength of approximately 200 nm or more is used, such as with a KrF excimer laser (wavelength of 248 nm).

In addition, in the above embodiment, an exposure apparatus EX in which air is arranged between the projection optical system PL and the wafer W was explained as an example, but it is also possible to apply the present invention to a liquid immersion type exposure apparatus that performs exposure processing in a status in which the space between the projection optical system PL and the wafer W has been filled with a liquid such as pure water or, for example, a solvent such as a fluorine oil or perfluoropolyether (PFPE). Since the refractive index n of pure water (water) with respect to exposure light with a wavelength of approximately 193 nm is nearly 1.44, in the case where ArF excimer laser light (wavelength of 193 nm) is used as the light source of the exposure light, on the wafer W, it is possible to shorten the wavelength to 1/n, that is, approximately 134 nm, to obtain high resolution. Also, the depth of focus is expanded by approximately n times, that is approximately 1.44 times, compared with it being in air, so in the case where it would be permissible to ensure the same level of depth of focus as the case in which it is used in air, it is possible to further increase the numerical aperture of the projection optical system PL, and resolution improves on this point as well.

In addition, the present invention can also be applied to a twin stage exposure apparatus having two stages on which substrates to be treated, such as wafers, are respectively mounted and which are independently movable in the XY direction. The structure and the exposure operation of the twin stage exposure apparatus are disclosed in, for example, Laid-open Japanese Patent Application Publication No. H10-163099, Laid-open Japanese Patent Application Publication No. H 10-214783 (corresponding to U.S. Patent Nos. 6,341,007, 6,400,441, 6,549,269 and 6,590,634), Laid-open Japanese WO Publication No. 2000-505958 (corresponding to U.S. Patent No. 5,969,441), and U.S. Patent No. 6,208,407, and, insofar as it is permitted by the relevant national law or regulations, the disclosures of these publications are each hereby incorporated by reference.

In addition, the present invention can also be applied to an exposure apparatus in which the stage for exposure that holds the substrate to be treated, such as a wafer, and the stage for measurement that mounts a reference member or a measurement sensor are separate. An exposure apparatus equipped with an exposure stage and a measurement stage is described in, for example, Laid-open Japanese Patent Application Publication No. H11-135400, and, insofar as it is permitted by the relevant national law or regulations, the disclosure of this document is hereby incorporated by reference.

In addition, the present invention can also be applied to not only exposure apparatuses that are used in the fabrication of semiconductor devices but to exposure apparatuses that are used in the manufacture of displays including liquid crystal display elements (LCD) and plasma displays, etc. and that transfer a device pattern onto a glass plate, exposure apparatuses that are used in the manufacture of thin-film magnetic heads and that transfer the device pattern onto a ceramic wafer, and exposure apparatuses used in the manufacture of image pickup elements such as CCDs, micro machines, and DNA chips.

In addition, the present invention can also be applied to exposure apparatuses that transfer the circuit pattern to glass substrates, silicon wafers, etc. in order to manufacture reticles or masks used in optical exposure apparatuses, EUV exposure apparatuses, x-ray exposure apparatuses and electron beam exposure apparatuses. Here, in exposure apparatuses that use DUV (deep ultraviolet) light or VUV (vacuum ultraviolet) light, in general, transmittance type reticles are used, and for the reticle substrate, silica glass, silica glass doped with fluorine, calcium fluorite, magnesium fluoride or rock crystal are used. Also, in proximity system x-ray exposure apparatuses or electron beam exposure apparatuses, transmittance type masks (stencil masks, membrane masks) are used, and a silicon wafer, etc. is used as the mask substrate. Note that this type of exposure apparatus is disclosed in WO99/34255, WO99/50712, WO99/66370, Laid-open Japanese Patent Application Publication No. H11-194479, Laid-open Japanese Patent Application Publication No. 2000-12453 and Laid-open Japanese Patent Application Publication No. 2000-29202.

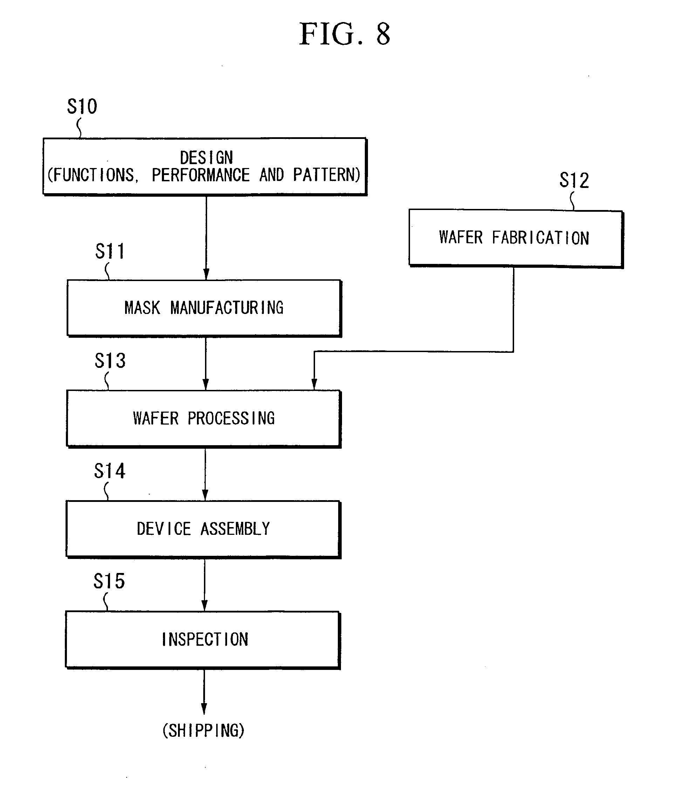

Next, an exposure apparatus and an exposure method in accordance with an embodiment of the present invention will be explained with respect to an embodiment of the micro device manufacturing method used in the lithography process. Fig. 8 is a flowchart that shows an example of the manufacturing process of the micro device (semiconductor chips such as IC and LSI, liquid crystal panels, CCDs, thin-film magnetic heads, and micro machines). As shown in Fig. 8, first, in step S10 (design step), function and performance design of the micro device (for example circuit design of semiconductor devices) are performed, and pattern design for achieving those functions is performed. Then, in step S 11 (mask manufacturing step), a mask (reticle) on which the designed circuit pattern is formed is manufactured. On the other hand, in step S12 (wafer fabrication step), a wafer is fabricated using a material such as silicon.

Next, in step S13 (wafer processing step), the mask and wafer prepared in step S10 ~ step S12 are used to form the actual circuit on the wafer, etc. by lithography technology, etc. as discussed below. Next, in step S14 (device assembly step), the wafer processed in step S13 is used to perform device assembly. In step S14, processes such as a dicing process, a bonding process, and a packaging process (chip sealing) are included as necessary. Lastly, in step S 15 (inspection step), inspections such as an operation confirmation test and a durability test for the micro device manufactured in step S 14 are performed. Having passed through these processes, the micro devices are completed and shipped.

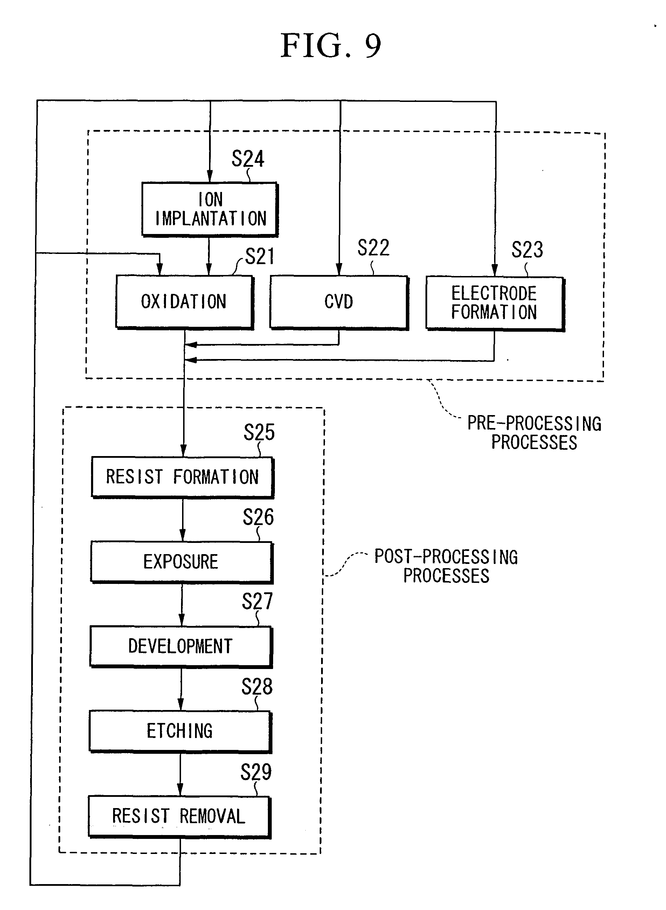

Fig. 9 is a drawing that shows an example of the detailed flow of step S13 of Fig. 8 in the case of a semiconductor device. In Fig. 9, the surface of the wafer is oxidized in step S21 (oxidation step). In step S22 (CVD step), an insulation film is formed on the wafer surface. In step S23 (electrode formation step), electrodes are formed on the wafer by vapor deposition. In step S24 (ion implantation step), ions are implanted in the wafer. The respective steps above, step S21 ~ step S24, constitute the pre-processing processes of the respective stages of wafer processing, and they are selected and executed according to the processes required for the respective stages.

In the respective stages of the wafer process, when the above pre-processing processes have ended, post-processing processes are executed in the following way. In these post-processing processes, first, in step S25 (resist formation step), the wafer is coated with a photosensitive agent. Then, in step S26 (exposure step), the circuit pattern of the mask is transferred to the wafer by the lithography system (exposure apparatus) and exposure method explained above. Then, in step S27 (development step), the exposed wafer is developed, and in step S28 (etching step), the exposed members of portions other than the portions where resist remains are removed by etching. Then, in step S29 (resist removal step), etching has been completed and the resist that has become unnecessary is removed. By repeatedly performing these pre-processing processes and post-processing processes, circuit patterns are multiply formed on the wafer.

If the micro device manufacturing method of the present embodiment explained above is used, in the exposure process (step S26), at least one of the scan directions, or the like, of the mask and the wafer is adjusted so that the rotation of the projected image resulting from the rotation of the projection optical system PL is offset to accurately transfer the pattern of the mask onto the wafer. For this reason, it is possible to produce devices with a high degree of integration having minute patterns with good yield.

### INDUSTRIAL APPLICABILITY

By adjusting at least one of the attitude and the scan direction of at least one of the mask and the substrate so that the rotation of the projected image on the substrate attributable to the rotation of the projection optical system is offset to expose the substrate, good exposure accuracy (resolution, transfer faithfulness, superimposing accuracy, etc.) can be obtained.

In addition, since it is possible to faithfully transfer the mask pattern onto the substrate with high exposure accuracy, it is possible to manufacture devices on which detailed patterns are formed with high yield, and it is also possible to reduce device manufacturing costs.

## Claims

1. An exposure method for transferring a pattern on a mask onto a substrate by using a catadioptric projection optical system that has a plurality of partial lens barrels that hold optical systems having optical axes that extend in mutually different directions, comprising:
measuring an amount of rotation of said catadioptric projection optical system about an optical axis which intersects at least one of said mask and said substrate; and
adjusting at least one of an attitude and a scan direction of at least one of said mask and said substrate based on a result of the measurement of the amount of rotation.

2. An exposure method in accordance with Claim 1, wherein:
said plurality of partial lens barrels include a first partial lens barrel, which has a first optical axis that extends from said mask to said substrate, and a second partial lens barrel, which has a second optical axis that intersects said first optical axis; and
the amount of rotation of said catadioptric projection optical system is obtained from a detection result of reflected light obtained by emitting detection light to reflecting mirrors attached to at least two parts of said first partial lens barrel.

3. An exposure method in accordance with Claim 1, wherein:
said plurality of partial lens barrels include a first partial lens barrel, which has a first optical axis that extends from said mask to said substrate, and a second partial lens barrel, which has a second optical axis that intersects said first optical axis; and
the amount of rotation of said catadioptric projection optical system is obtained from a result of detection of position measurement marks attached to at least two parts of said first partial lens barrel.

4. An exposure method in accordance with Claim 1, wherein the amount of rotation of said catadioptric projection optical system is obtained from a detection result of an acceleration sensor attached to said catadioptric projection optical system.

5. An exposure method for transferring a pattern on a mask onto a substrate by using a catadioptric projection optical system that has a partial lens barrel that holds an optical system having optical axes that extend in mutually different directions while scanning the mask and the substrate, comprising:
adjusting at least one of an attitude and a scan direction of at least one of said mask and said substrate in accordance with an amount of rotation of said catadioptric projection optical system about an optical axis intersecting at least one of said mask and said substrate.

6. An exposure apparatus which has a catadioptric projection optical system having a plurality of partial lens barrels having optical axes that extend in mutually different directions, a mask stage that holds a mask, and a substrate stage that holds a substrate, and which transfers a pattern on said mask onto said substrate via said catadioptric projection optical system, comprising:
a measuring device which measures an amount of rotation of said catadioptric projection optical system about an optical axis that intersects at least one of said mask and said substrate; and
a control device which adjusts at least one of an attitude and a scan direction of at least one of said mask stage and said substrate stage based on a result of the measurement of the amount of rotation.

7. An exposure apparatus in accordance with Claim 6, wherein said plurality of partial lens barrels include a first partial lens barrel, which has a first optical axis that extends from said mask to said substrate, and a second partial lens barrel, which has a second optical axis that intersects said first optical axis.

8. An exposure apparatus in accordance with Claim 7, wherein said measuring device measures the amount of rotation of said catadioptric projection optical system by making at least one of said plurality of partial lens barrels a subject for the measurement.

9. An exposure apparatus in accordance with Claim 8, wherein said measuring device emits detection light to reflecting mirrors attached to at least two parts of said first partial lens barrel and obtains the amount of rotation of said catadioptric projection optical system from position information of each of said reflecting mirrors.

10. An exposure apparatus in accordance with Claim 8, wherein said measuring device observes position measurement marks attached to at least two parts of said first partial lens barrel and obtains the amount of rotation of said catadioptric projection optical system from a result of the observation.

11. An exposure apparatus in accordance with Claim 8, wherein said measuring device obtains the amount of rotation of said catadioptric projection optical system from a detection result of an acceleration sensor attached to said catadioptric projection optical system.

12. An exposure apparatus in accordance with Claim 7, wherein said second partial lens barrel includes a reflecting mirror and a lens.

13. A device manufacturing method, comprising:
an exposure step of performing an exposure process on a substrate using an exposure method in accordance with any one of Claim 1 to Claim 5 or an exposure apparatus in accordance with any one of Claim 6 to Claim 12; and
a development step of performing development of the substrate that has gone through said exposure step.
